# EUROPEAN PATENT APPLICATION

(11) **EP 4 776 827 A1**
(43) Date of publication of application: **15.07.2026**
(21) Application number: 25220088.6
(22) Date of filing: 02.12.2025
(51) Int. Cl.: H10P 72/00, H10P 72/50

(54) **POSITIONING DEVICE FOR POSITIONING A FIRST SUBSTRATE RELATIVE TO A SECOND SUBSTRATE**

(30) Priority: 13.01.2025 NL 2039581
(71) Applicant: SUSS MicroTec Solutions GmbH & Co. KG, 75447 Sternenfels (DE)
(72) Inventor: Schoewel, Michael, 75447 Sternenfels (DE)
(74) Representative: Prinz & Partner mbB

(57) **Abstract**

A positioning device (10) for positioning a first substrate (14) relative to a second substrate (18) is described. The positioning device (10) comprises a first substrate holder (12) for holding the first substrate (14); a second substrate holder (16) for holding the second substrate (18), wherein the first substrate holder (12) and the second substrate holder (16) are mounted such that a distance between them is adjustable; and a distance-control element (20) which can be inserted between the first substrate holder (12) and the second substrate holder (16), wherein the distance-control element (20) comprises a body (22) with a fluid inlet (24), a first substrate fluid outlet (26) which is connected to the fluid inlet (24) and which is directed towards the first substrate holder (12) and configured to eject pressurized fluid from the body (22) in the direction of the first substrate (14) when the first substrate (14) is located in the first substrate holder (12), and with a second substrate fluid outlet (28) which is connected to the fluid inlet (24) and which is directed towards the second substrate holder (16) and configured to eject pressurized fluid from the body (22) in the direction of the second substrate (18) when the second substrate (18) is located in the second substrate holder (16).

## Description

The present invention relates to a positioning device for positioning a first substrate relative to a second substrate.

To manufacture microstructured and/or nanostructured components, for example semiconductor devices, it is often necessary to precisely align a first substrate, for example a wafer, relative to a second substrate, for example a mask.

The wafer and the mask are typically brought into close proximity and then are shifted laterally relative to each other to achieve the desired alignment.

Due to bowing of the wafer and/or mask and/or imperfections in the alignment process, an undesired local contact between the mask and the wafer can occur which can cause scratches or even more severe damage to the wafer and/or mask.

To improve the process control, spherical spacers, for example small ceramic balls, can be placed between the mask and the wafer during the alignment. The spherical spacers form Hertzian contacts to the wafer as well as the mask. While laterally shifting the wafer and mask relative to each other, the spherical spacers can rotate, thereby preventing any scratch marks on the mask or the wafer.

However, using spherical spacers also has some disadvantages. Due to their small size of typically less than 2 mm, the spherical spacers are difficult to handle. Furthermore, the use of spherical spacers is restricted to areas of the mask and wafer without any geometrical structure or contact sensitive surface.

It is therefore the object of the invention to provide a means to enable a technically simple and reliable close proximity alignment of a wafer relative to a mask.

The object of the invention is solved by a positioning device for positioning a first substrate, e.g. a wafer, relative to a second substrate, e.g. a mask. The positioning device comprises a first substrate holder for holding the first substrate and a second substrate holder for holding the second substrate. The first substrate holder and the second substrate holder are mounted such that a distance between them is adjustable. The positioning device furthermore comprises a distance-control element which can be inserted between the first substrate holder and the second substrate holder. The distance-control element comprises a body with a fluid inlet and a first substrate fluid outlet which is connected to the fluid inlet and which is directed towards the first substrate holder and configured to eject pressurized fluid from the body in the direction of the first substrate when the first substrate is located in the first substrate holder. The distance-control element furthermore comprises a second substrate fluid outlet which is connected to the fluid inlet and which is directed towards the second substrate holder and configured to eject pressurized fluid from the body in the direction of the second substrate when the second substrate is located in the second substrate holder.

The pressurized fluid is for example pressurized air, nitrogen or an inert gas.

By ejecting the pressurized fluid in the direction of the first substrate as well as in the direction of the second substrate, fluid cushions, for example air cushions, are created between the distance-control element and the second substrate as well as between the distance-control element and the first substrate. The fluid cushions prevent any physical contact between the distance-control element and the second substrate, between the distance-control element and the first substrate and thus also between the second substrate and the first substrate. Hence, the second substrate and the first substrate can be positioned in close proximity and shifted relative to each other without any physical contact to a rigid object, thereby decreasing the risk of damaging the second substrate and/or the first substrate.

In particular, the first substrate is a wafer and/or the second substrate is a mask. Thus, the positioning device according to the invention is especially suitable for lithography purposes.

Alternatively, the first substrate can be a mask, an imprint stamp or any other type of substrate and/or the second substrate can be a wafer, an imprint stamp or any other type of substrate. Accordingly, the positioning device according to the invention can be used for many different purposes.

In a preferred embodiment, the distance between the distance-control element and the first substrate and/or the distance between the distance-control element and the second substrate can be controlled by regulating the pressure of the pressurized fluid. In other words, the distance-control element can be applied as a distance-setting element to set a desired distance between the first substrate and the second substrate by ejecting pressurized fluid of a certain pressure through the respective fluid outlets.

Additionally or alternatively, the distance-control element can be used as distance-measuring element to measure the distance between the distance-control element and the first substrate and/or the distance between the distance-control element and the second substrate and/or the distance between the first substrate and the second substrate by monitoring or measuring the pressure of the fluid ejected through the respective fluid outlets. The measured distance can be used as input in subsequent process steps, e.g. for a subsequent wedge error compensation. The wedge error compensation can be performed by the distance-control element functioning as a distance-setting element or by other distance-setting means, for example actuators, particularly piezo-actuators, that control the tilt of the first substrate holder and/or the second substrate holder.

In one technically easy to implement variant, the body of the distance-control element is formed by two plates arranged at a distance from each other, and a fluid impermeable connection, which connects the two plates along their perimeter. The plates are for example metal plates.

The connection is for example a welding line. By welding the two plates, a reliable and durable connection is created. Furthermore, compared to other connection types which rely for example on rubber sealing elements, a higher stiffness of the body can be achieved which facilitates the handling, in particular inserting it in between the first substrate and the second substrate.

According to an aspect of the invention, the distance-control element comprises at least one spacer arranged between the two plates. The spacer precisely defines the distance between the two plates. Hence, a well-defined channel is formed between the two plates through which the pressurized fluid can flow from the fluid inlet to the respective fluid outlets. Furthermore, the spacers can prevent collapse of the channel, in case a force is accidentally applied on either of the plates.

In a further variant, the second substrate fluid outlet and the first substrate fluid outlet of the distance-control element are formed by a through-hole extending through both plates. This is technically easy to realize, for example by drilling or lasering through both plates in a single processing step. Furthermore, a balanced fluid flow in opposite directions can be achieved with the through-hole. This results in a homogeneous distribution of forces originating from the pressurized fluid flowing against the surface of the second substrate and the first substrate and thus in an improved process control.

It is also conceivable that the body of the distance-control element comprises at least one further second substrate fluid outlet and at least one further first substrate fluid outlet, wherein each of the second substrate fluid outlets forms a fluid outlet pair with one of the first substrate fluid outlets and wherein the fluid outlet pairs are distributed across the body.

Of course, the distance-control element can also comprise more than two fluid outlet pairs, for example 50 or 100 fluid outlet pairs.

With the two or more fluid outlet pairs, a homogeneous distribution of forces resulting from the pressurized fluid being ejected against the second substrate as well as the first substrate can be achieved. This enables a precise distance control across the whole first substrate and second substrate.

In a further variant of the positioning device, the body of the distance-control element comprises at least two fluid channels, wherein each of the fluid channels is connected to at least one of the fluid outlet pairs, and wherein each of the fluid channels is configured to be supplied with a pressurized fluid of a certain fluid pressure independent of the other fluid channel(s).

This allows ejecting the pressurized fluid from different fluid outlet pairs with a different pressure. For example, pressurized fluid can be ejected from one of the fluid outlet pairs against a certain area of the first substrate and second substrate with a first pressure and from a different fluid outlet pair against another area of the first substrate and second substrate with a second pressure that differs from the first pressure. Hence, different forces can be applied at different lateral positions of the first substrate and the second substrate. By precisely regulating the fluid pressures and thus the forces acting on the second substrate as well as the first substrate, the distance between them can be adjusted locally. In this way, wedge errors can be corrected.

According to another aspect, the positioning device further comprises a fluid supply for supplying pressurized fluid to the inlet of the distance-control element, and a control unit configured to control the fluid pressure of the fluid supplied to the distance-control element. By controlling the fluid pressure, the local or average distance between the first substrate and the second substrate can be adjusted. For example, raising the fluid pressure, results in an increased force pushing the second substrate and the first substrate and thus also their respective holders away from each other, such that the distance between them increases.

Of course, the positioning device can also comprise a means to reduce the local or global distance between the second substrate and the first substrate, for example a mechanism that applies a force to the second substrate holder and/or the first substrate holder to push them together, or an elastic element connecting the respective holders.

In another variant, the positioning device further comprises a pressure sensor configured to measure a fluid pressure of the pressurized fluid supplied to the distance-control element. The control unit is for example configured to determine a local distance between the first substrate and the second substrate based on the measured fluid pressure. In other words, the pressurized fluid cannot only be used to adjust the distance but also to measure the distance between the second substrate and the first substrate.

According to another aspect of the invention, the positioning device further comprises at least a second distance-control element, which can be inserted between the first substrate holder and the second substrate holder. The second distance element can be identical in construction to the first distance-control element. It comprises a second body with a second fluid inlet, a second first substrate fluid outlet which is connected to the second fluid inlet and which is directed towards the first substrate holder and configured to eject pressurized fluid from the second body in the direction of the first substrate when the first substrate is located in the first substrate holder. The second body furthermore comprises a second second substrate fluid outlet which is connected to the second fluid inlet and which is directed towards the second substrate holder and configured to eject pressurized fluid from the second body in the direction of the second substrate, when the second substrate is located in the second substrate holder. The control unit is configured to control the fluid pressure of pressurized fluid supplied to the different distance-control elements independent of one another.

The application of two or more distance-control elements allows ejecting pressurized fluid with a different pressure at different lateral positions of the second substrate and the first substrate. For example, pressurized fluid can be ejected from one of the distance-control elements against a certain area of the first substrate and the second substrate with a first pressure and from a different distance-control element against another area of the first substrate and the second substrate with a second pressure that differs from the first pressure. Hence, different forces can be applied at different lateral positions of the first substrate and the second substrate. By precisely regulating the fluid pressures and thus the forces acting on the second substrate as well as on the first substrate, the distance between them can be adjusted locally. In this way, wedge errors can be corrected.

Further advantages and features will become apparent from the following description of the invention and from the appended figures, which show a nonlimiting exemplary embodiment of the invention and in which:
- Fig. 1 schematically shows a first exemplary embodiment of a positioning device according to the invention in a side view;
- Fig. 2 schematically shows a second exemplary embodiment of a positioning device according to the invention in a side view; and
- Fig. 3 schematically shows a third exemplary embodiment of a positioning device according to the invention in a side view.

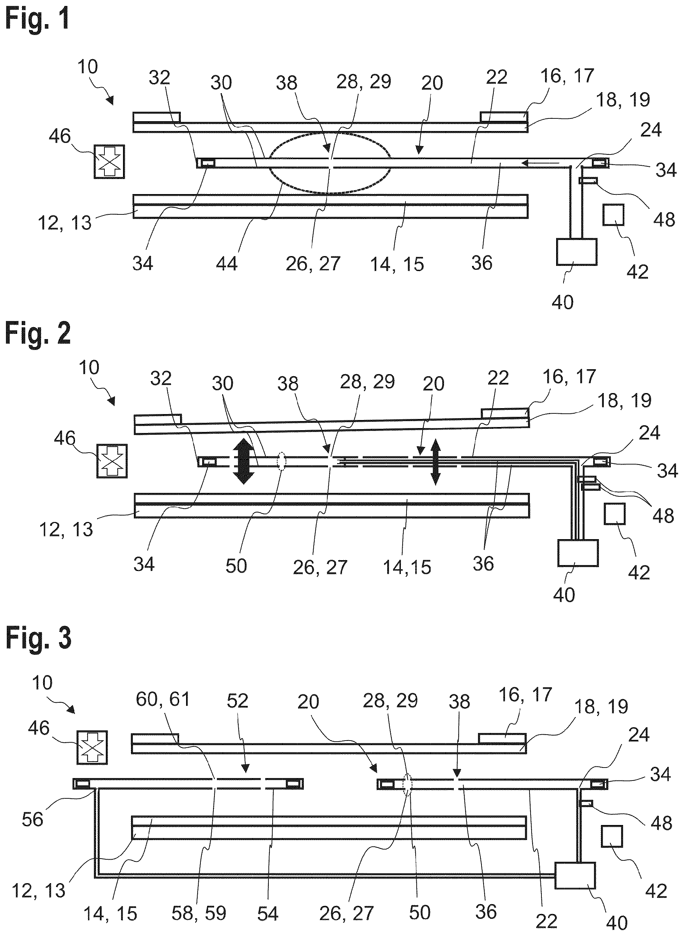

Fig. 1 schematically shows a first embodiment of a positioning device 10. The positioning device 10 comprises a first substrate holder 12 for holding a first substrate 14 and a second substrate holder 16 for holding a second substrate 18.

In the following, all embodiments of the positioning device 10 are shown with the first substrate holder 12 being a wafer holder 13, the first substrate 14 being a wafer 15, the second substrate holder 16 being a mask holder 17 and the second substrate 18 being a mask 19. This is, of course, to be understood as an example and not as a limitation of the invention.

For example, the first substrate 14 and/or the second substrate 18 can alternatively be a wafer, a mask, an imprint stamp or any other type of substrate.

The wafer holder 13 and the mask holder 17 are mounted such that a distance between them is adjustable.

The positioning device 10 furthermore comprises a distance-control element 20 which can be inserted between the wafer holder 13 and the mask holder 17 and with which the mask 19 located in the mask holder 17 and the wafer 15 located in the wafer holder 13 can be positioned relative to each other with a defined distance between them.

The distance-control element 20 comprises a body 22 with a fluid inlet 24, a first substrate fluid outlet 26 and a second substrate fluid outlet 28.

In the following, all embodiments of the distance-control element 20, 52 are shown with the first substrate fluid outlet 26, 58 being a wafer fluid outlet 27, 59 and the second substrate fluid outlet 28, 60 being a mask fluid outlet 29, 61. This is, of course, to be understood as an example and not as a limitation of the invention.

The body 22 of the distance-control element 20 is formed by two metal plates 30, which are arranged at a distance from each other, and a fluid impermeable connection 32 that connects the two plates 30 around their perimeter. The fluid impermeable connection 32 is for example a welding line.

The distance-control element 20 furthermore comprises multiple spacers 34 arranged between the two plates 30 to keep them at a defined distance from one another such that a fluid channel 36 is formed between them that connects the fluid inlet 24 to the respective fluid outlets 26, 28 or 27, 29, respectively.

In the embodiment shown in Fig. 1, the mask fluid outlet 29 and the wafer fluid outlet 27 are both formed by a through-hole 38 extending through both plates 30.

The distance-control element 20 can be positioned such that the wafer fluid outlet 27 is directed towards the wafer holder 13 and that the mask fluid outlet 29 is directed towards the mask holder 17.

The positioning device 10 furthermore comprises a fluid supply 40, for example an air compressor, for supplying pressurized fluid to the fluid inlet 24 of the body 22 and a control unit 42 with which the fluid pressure of the pressurized fluid supplied to the inlet 24 can be controlled.

To control the distance between the wafer 15 and the mask 19, pressurized fluid can be supplied by the fluid supply 40 to the inlet 24 of the body 22 of the distance-control element 20.

The pressurized fluid flows through the fluid channel 36 towards the wafer fluid outlet 27 and the mask fluid outlet 29.

The pressurized fluid is then ejected from the body 22 through the wafer fluid outlet 27 in the direction of the wafer 15, when the wafer 15 is located in the wafer holder 13 and through the mask fluid outlet 29 in the direction of the mask 19, when the mask 19 is located in the mask holder 17.

The ejected pressurized fluid forms fluid cushions 44 between the distance-control element 20 and the mask 19 as well as between the distance-control element 20 and the wafer 15. By means of the fluid cushions 44, forces are applied on the wafer 15 and on the mask 19. The applied forces push the wafer 15 and the mask 19 and thus also the respective holders 13, 17 away from each other or at least prevent them from moving closer together and contacting each other.

In the embodiment shown in Fig. 1, the fluid pressure and thus also the distance between the wafer 15 and the mask 19 can be controlled with the control unit 42. In other words, the distance-control element 20 can be applied as a distance-setting element to set the distance between the wafer 15 and the mask 19.

Optionally, the positioning device 10 further comprises a means 46 to reduce the local or global distance between the mask holder 17 and the wafer holder 13, for example a mechanism with which a defined force can be applied on the mask holder 17, the wafer holder 13 or both to push them closer together or at least to prevent them from moving further apart from each other.

The positioning device 10 shown in Fig. 1 further comprises a pressure sensor 48, configured to measure a fluid pressure of the pressurized fluid supplied to the distance-control element 20. The control unit 42 is configured to determine a distance between the wafer 15 located in the wafer holder 13 and the mask 19 located in the mask holder 17 based on the measured fluid pressure. In other words, the distance-control element 20 can be applied as a distance-measuring element to measure the distance between the wafer 15 and the mask 19 by monitoring or measuring the pressure of the fluid ejected through the fluid outlets 27, 29. The measured distance can be used as input for a subsequent wedge error compensation. The wedge error compensation can be performed by the distance-control element 20 functioning as a distance-setting element or by other distance-setting means, for example actuators, particularly piezo-actuators, that control the tilt of the wafer holder 13 and/or the mask holder 17.

Fig. 2 schematically shows a second exemplary embodiment of a positioning device 10 according to the invention. The second embodiment corresponds in several essential aspects to the first embodiment, so that only the differences will be discussed. Identical and functionally identical parts are provided with the same reference symbols.

In the second embodiment, the body 22 of the distance-control element 20 comprises at least one further mask fluid outlet 29 and at least one further wafer fluid outlet 27. In other words, the body 22 comprises two or more wafer fluid outlets 27 as well as two or more mask fluid outlets 29.

Each of the mask fluid outlets 29 forms a fluid outlet pair 50 with one of the wafer fluid outlets 27. The fluid outlet pairs 50 are homogeneously distributed across the body 22.

The positioning device 10 shown in Fig. 2 furthermore comprises two or more fluid channels 36. Each of the fluid channels 36 is connected to at least one of the fluid outlet pairs 50.

The fluid pressure of the pressurized fluid supplied to the different fluid channels 36 can be individually adjusted with the control unit 42.

This allows ejecting the pressurized fluid from different fluid outlet pairs 50 with a different pressure and thus to apply different forces at different lateral positions onto the wafer 15 and the mask 19. The different forces are symbolized in Fig. 2 with differently sized double arrows.

By precisely regulating the fluid pressures of the individual fluid channels 36 and thus the forces acting on the mask 19 as well as the wafer 15 in different areas, the distance between them can be adjusted locally. In this way, wedge errors can be corrected.

Fig. 3 schematically shows a third exemplary embodiment of a positioning device 10 according to the invention. The third embodiment corresponds in several essential aspects to the first and the second embodiment, so that only the differences will be discussed. Identical and functionally identical parts are provided with the same reference symbols.

In the third embodiment, the positioning device 10 comprises a second distance-control element 52 which can be inserted between the wafer holder 13 and the mask holder 17.

The second distance-control element 52 comprises a second body 54 with a second fluid inlet 56, a second wafer fluid outlet 59 which is connected to the second fluid inlet 56 and which is directed towards the wafer holder 13 and configured to eject pressurized fluid from the second body 54 in the direction of the wafer 15 when the wafer 15 is located in the wafer holder 13.

The second body 54 furthermore comprises a second mask fluid outlet 61 which is connected to the second fluid inlet 56 and which is directed towards the mask holder 17 and configured to eject pressurized fluid from the second body 54 in the direction of the mask 19, when the mask 19 is located in the mask holder 17.

In the third embodiment, the control unit 42 is configured to control the fluid pressure of pressurized fluid supplied to the different distance-control elements 20, 52 independent of one another.

This allows ejecting the pressurized fluid from the different bodies 22, 54 with different pressures and thus, to apply different forces at different lateral positions onto the wafer 15 and the mask 19.

Similar to the second embodiment, the forces acting on the mask 19 as well as on the wafer 15 and thus the distance between them can be adjusted locally by individually regulating the fluid pressure of the pressurized fluid supplied to both distance-control elements 20, 52.

This enables a precise and contact-free control of the distance between the mask 19 and the wafer 15, in particular during an alignment process, in which the mask 19 and the wafer 15 are shifted laterally relative to each other.

## Claims

1. Positioning device for positioning a first substrate (14) relative to a second substrate (18), comprising:
a first substrate holder (12) for holding the first substrate (14);
a second substrate holder (16) for holding the second substrate (18), wherein the first substrate holder (12) and the second substrate holder (16) are mounted such that a distance between them is adjustable; and
a distance-control element (20) which can be inserted between the first substrate holder (12) and the second substrate holder (16), wherein the distance-control element (20) comprises a body (22) with a fluid inlet (24), a first substrate fluid outlet (26) which is connected to the fluid inlet (24) and which is directed towards the first substrate holder (12) and configured to eject pressurized fluid from the body (22) in the direction of the first substrate (14) when the first substrate (14) is located in the first substrate holder (12), and with a second substrate fluid outlet (28) which is connected to the fluid inlet (24) and which is directed towards the second substrate holder (16) and configured to eject pressurized fluid from the body (22) in the direction of the second substrate (18) when the second substrate (18) is located in the second substrate holder (16).

2. Positioning device according to claim 1, wherein the first substrate (14) is a wafer (15) and/or the second substrate (18) is a mask (19).

3. Positioning device according to claim 1 or 2, wherein a distance between the distance-control element (20) and the first substrate (14) and/or the distance between the distance-control element (20) and the second substrate (18) can be controlled by regulating the pressure of the pressurized fluid.

4. Positioning device according to anyone of the preceding claims, wherein the body (22) of the distance-control element (20) is formed by two plates (30) arranged at a distance from each other, and a fluid impermeable connection (32) which connects the two plates (30) along their perimeter.

5. Positioning device according to claim 4, wherein the connection (32) is a welding line.

6. Positioning device according to claim 4 or 5, wherein the distance-control element (20) comprises at least one spacer (34) arranged between the two plates (30).

7. Positioning device according to anyone of the claims 4 to 6, wherein the second substrate fluid outlet (28) and the first substrate fluid outlet (26) of the distance-control element (20) are formed by a through-hole (38) extending through both plates (30).

8. Positioning device according to anyone of the preceding claims, wherein the body (22) of the distance-control element (20) comprises at least one further second substrate fluid outlet (28) and at least one further first substrate fluid outlet (26), wherein each of the second substrate fluid outlets (28) forms a fluid outlet pair (50) with one of the first substrate fluid outlets (26) and wherein the fluid outlet pairs (50) are distributed across the body (22).

9. Positioning device according to claim 8, wherein the body (22) of the distance-control element (20) comprises at least two fluid channels (36), wherein each of the fluid channels (36) is connected to at least one of the fluid outlet pairs (50), and wherein each of the fluid channels (36) is configured to be supplied with a pressurized fluid of a certain fluid pressure independent of the other fluid channel(s) (36).

10. Positioning device according to anyone of the preceding claims, further comprising a fluid supply (40) for supplying pressurized fluid to the inlet (24) of the distance-control element (20), and a control unit (42) configured to control the fluid pressure of the fluid supplied to the distance-control element (20).

11. Positioning device according to claim 10, further comprising a pressure sensor (48) configured to measure a fluid pressure of the pressurized fluid supplied to the distance-control element (20), wherein the control unit (42) is configured to determine a local distance between the first substrate (14) and the second substrate (18) based on the measured fluid pressure.

12. Positioning device according to claim 10 or 11, further comprising at least a second distance-control element (52) which can be inserted between the first substrate holder (12) and the second substrate holder (16), wherein the second distance-control element (52) comprises a second body (54) with a second fluid inlet (56), a second first substrate fluid outlet (58) which is connected to the second fluid inlet (56) and which is directed towards the first substrate holder (12) and configured to eject pressurized fluid from the second body (54) in the direction of the first substrate (14) when the first substrate (14) is located in the first substrate holder (12), and with a second second substrate fluid outlet (60) which is connected to the second fluid inlet (56) and which is directed towards the second substrate holder (16) and configured to eject pressurized fluid from the second body (54) in the direction of the second substrate (18), when the second substrate (18) is located in the second substrate holder (16), wherein the control unit (42) is configured to control the fluid pressure of the pressurized fluid supplied to the different distance-control elements (20, 52) independent of one another.
